(19) Europäisches Patentamt
European Patent Office
Office européen des brevets

(11) **EP 4 657 161 A1**

(12) **EUROPEAN PATENT APPLICATION**

(43) Date of publication:
**03.12.2025 Bulletin 2025/49**

(21) Application number: **24178687.0**

(22) Date of filing: **29.05.2024**

(51) International Patent Classification (IPC):
**G03F 7/20** (2006.01)   **G03F 7/00** (2006.01)

(52) Cooperative Patent Classification (CPC):
**G03F 7/70616; G03F 7/705; G03F 7/70525**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **ASML Netherlands B.V.
5500 AH Veldhoven (NL)**

(72) Inventors:
• **ONOSE, Alexandru
5500 AH Veldhoven (NL)**

• **BOTARI, Tiago
5500 AH Veldhoven (NL)**
• **DEIST, Timo, Matthias
5500 AH Veldhoven (NL)**
• **CERFONTAINE, Pascal
5500 AH Veldhoven (NL)**
• **MEDVEDYEVA, Mariya, Vyacheslavivna
5500 AH Veldhoven (NL)**
• **ZHOU, Zili
5500 AH Veldhoven (NL)**

(74) Representative: **ASML Netherlands B.V.
Corporate Intellectual Property
P.O. Box 324
5500 AH Veldhoven (NL)**

(54) **METHOD AND SYSTEM FOR PREDICTING METROLOGY DATA USING A NEURAL NETWORK**

(57)    A method is presented for generating, using a neural network, predicted metrology data of a patterned portion. The neural network comprises an input network and an output network. The input network comprises a common input model and a specific input model, wherein the common input model has been trained by a process in which the common input model processes data based on training metrology data generated by a plurality of metrology systems, and the specific input model has been trained by a process in which the specific input model processes data based on training metrology data generated only by a first metrology system.

## Fig. 4

**Description**

FIELD

The present invention relates to a method and a system for generating predicted metrology data using a neural network.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-$k_1$ lithography may be used to process features with dimensions smaller than the classical resolution limit of a lithographic apparatus. In such process, the resolution formula may be expressed as CD = $k_1 \times \lambda$/NA, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

After a substrate has been patterned using the lithographic apparatus, it is often desirable to inspect the substrate (i.e. to measure properties of the patterned structure), e.g. to determine whether the produced pattern accurately resembles the intended design. To this end, a metrology system (e.g. optical metrology systems, scanning electron microscopes (SEM), soft x-ray metrology systems, and the like) can be used to acquire metrology data (e.g. an image) of the patterned substrate. The acquired metrology data is often used to adjust process parameters (e.g. scanner properties, etch process parameters, and the like) which specify the manufacturing process. Frequently it is desirable to use a large number of metrology systems in parallel to control the fabrication process in a semiconductor fabrication plant. However, in practice, different instances of nominally identical metrology systems generate (slightly) different metrology data for the same target (this phenomenon is also referred to as "tool-mismatch"). Tool-mismatch is caused, for example, by different instances of the metrology tool suffering from different aberrations, different degrees of drift, different degradation during their lifetime, and so on. Conventionally this problem is addressed by imposing tight tolerances on the hardware components of the metrology systems. Such an approach however results in increased cost.

It is therefore desirable to provide techniques that can mitigate variations in metrology data generated by different metrology system without relying on hardware-based solutions.

SUMMARY

The present invention aims to provide new and useful methods for predicting metrology data using a neural network which receives, as input, metrology data generated by inspecting a target using a first metrology system (and information about the configuration (e.g. the type of the tool; and/or its settings at the time that the metrology data was created) of the first metrology system) and determines, from the input, predicted metrology data which would have been generated by inspecting the target using a second metrology system. This means that the output data of the neural network "looks" like metrology data generated by the second metrology system. The output of the neural network can then be compared to metrology data that has actually been generated by the second metrology system without being affected by tool-mismatch.

In broad terms, the present invention proposes a neural network that processes metrology data to effectively remove characteristics which are specific to the metrology system used to generate the input metrology data and to add the characteristics specific to a target metrology system. One way of implementing this is for the neural network to encode the input metrology data using an input network that has learnt the characteristics of the metrology system used to generate the input metrology data (i.e. the input network has been trained using training metrology data generated by this metrology system). An output network that has learnt the characteristics of the target metrology system (i.e. the output network that has been trained using training metrology data generated by the target metrology system) can then generate the predicted metrology data from the encoded metrology data.

According to a first aspect, there is provided a method generating, using a neural network, predicted metrology data of a patterned portion of a substrate patterned using a lithographic apparatus. The neural network comprises an input network and an output network. The input network comprises a common input model and a specific input model, wherein the common input model has been trained by a process in which the common input model processes data based on training metrology data generated by a plurality of metrology systems, and the specific input model has been trained by a process in which the specific input model processes data based on training metrology data generated only by a first metrology system. The method comprises:

    receiving metrology data of the patterned portion generated using the first metrology system;
    obtaining configuration data specifying a configuration of the first metrology system used to generate the metrology data (e.g. configuration data may comprise data characterizing the first metrology system and/or setting data specifying operating parameters of the first metrology system at the time the metrology data was captured);
    processing, using the common input model and the specific input model, the metrology data and the configuration data to generate an encoding of the patterned portion; and
    processing, using the output network of the neural network, the encoding of the patterned portion to generate the predicted metrology data, the predicted metrology data being a prediction of metrology data which would have been generated by inspecting the patterned portion using a second metrology system.

The inventors have found that it is advantageous to use a neural network architecture that uses an input network comprising a common input model (trained on training metrology data generated by a plurality of metrology systems) and a specific input model (trained only on training metrology data generated by the first metrology system). One of the advantages of this architecture is that training metrology data from at least one other metrology system (e.g. a third metrology system different from the first metrology system) may be used to train parts of the neural network, e.g. the common input model. The common input model makes the task of the specific input model easier. Thus, the specific input model can have fewer variable parameters (e.g. fewer than the common input model), so training it is less computationally expensive and can be performed with reduced training data relating to the first metrology system. Furthermore, the neural network can conveniently be adapted to work for a new first metrology system by simply training a corresponding specific input model while the common input model and the output network do not need to be re-trained. Note that the performance of the specific input model for the new first metrology system would typically be as high as that of the specific input models of first metrology systems used in the training of the common input model, provided that the new first metrology system is similar to (e.g. not out of the distribution of) the first metrology systems used in the training of the common input model.

In some implementations, a first one of the common input model and the specific input model may be configured to process the metrology data to generate an encoding of the metrology data, and a second one of the common input model and the specific input model being configured to process the encoding of the metrology data. For example, the first one of the common input model and the specific input model may be the common input model, and the second one of the common input model and the specific input model may be the specific input model.

In some implementations, processing the metrology data and the configuration data to generate an encoding of the patterned portion may comprise:

    processing, using the first one of the common input model and the specific input model, the metrology data to generate an encoding of the metrology data; and
    processing, using the second one of the common input model and the specific input model, the encoding of the metrology data and the configuration data to generate the encoding of the patterned portion.

In some implementations, the plurality of metrology systems used in the process to train the common input model may comprise the first metrology system, the second metrology system and at least one further metrology system.

In some implementations, the method may further comprise a step of obtaining target configuration data specifying a configuration of the second metrology system. In this case, the predicted metrology data may be a prediction of metrology data which would have been generated by inspecting the patterned portion using the second metrology system configured according to the target configuration data.

In some implementations, the output network may comprise a common output model trained by a process in which the common output model processes data based on training metrology data generated by a plurality of metrology systems. The plurality of metrology systems used in the process to train the common output model may comprise the first metrology system, the second metrology system and at least one further metrology system.

In some implementations, the output network may further comprise a specific output model trained by a process in which the specific output model processes data based on training metrology data generated only by the second metrology system.

It is advantageous to use a neural network architecture that uses a common output model and a metrology system specific input model since this architecture means the network can conveniently be adapted to work for different target metrology systems by simply training a corresponding specific output model while the common output model does not need to be re-trained.

In some implementations, a first one of the common output model and the specific output model may be configured to process data generated by the input network, and a second one of the common output model and specific output model may be configured to process the output of the first one of the common output model and specific output model.

In some implementations, the first one of the common output model and the specific output model may be the specific output model, and the second one of the common output model and the specific output model may be the common output model.

In some implementations, the plurality of metrology systems used in the process to train the common output model may comprise the first metrology system, the second metrology system and at least one further metrology system.

In some implementations, processing the encoding of the patterned portion to generate the predicted metrology data may comprise processing, using the specific output model, the encoding of the patterned portion and the target configuration data to generate the encoding of the predicted metrology data, and processing, using the common output model, the encoding of the predicted metrology data to generate the predicted metrology data.

In some implementations, processing the metrology data and the configuration data of the first metrology system to generate an encoding of the patterned portion may comprise:

processing, using the common input model, the metrology data to generate an encoding of the metrology data;
processing, using the specific input model, the encoding of the metrology data and the configuration data of the first metrology system to generate first encoded data;
processing, using the specific output model, the encoding of the metrology data and the target configuration data to generate second encoded data; and
combining the first and second encoded data to generate the encoding of the patterned portion. For example, the first and second encoded data may be combined by concatenating the first and second encoded data.

In some implementations, at least one of the first metrology system and the second metrology system is a real-world metrology system.

In some implementations, at least one of the first metrology system and the second metrology system may be a simulated metrology system (e.g. a computational model based on physics).

In some implementations, the neural network may further comprise an application-specific model corresponding to an application type, from a set of application types, associated with the patterned portion, the application-specific model being configured to process data from the input network and to provide data to the output network data. The predicted metrology data may be generated by processing the encoding of the patterned portion using the output network of the neural network and the data provided by the application model. The application-specific model has been trained by a process in which the application-specific model processes data based on training metrology data of patterned portions associated with the application type. Here the term "application" refers to a difference in the characteristics of the patterned substrate used to produce the training metrology data for the first metrology system, and the training data for the second metrology system. For example, the two sets of training data may be produced by inspecting substrates patterned according to different respective uDBO (micro-diffraction based overlay) target designs.

In some implementations, the configuration data of the first metrology system may comprise reference metrology data of a reference target generated using the first metrology system configured in the same configuration as used to generate the received metrology data.

In some implementations, the metrology data may comprise image data.

In some implementations, the different metrology systems may be different instances of an optical dark-field microscope.

In some implementations, the configuration data of the first metrology system comprises information specifying a spectral density of light used to generate the metrology data.

In some implementations, the different metrology systems may be different beams of a multi-beam scanning electron microscope.

In some implementations, the metrology data may comprise a pupil representation defining a distribution of radiation in a pupil plane of the metrology system.

In some implementations, the neural network model may comprise a U-Net architecture.

In some implementations, the neural network model may comprise one or more skip connections. The one or more skip connections may comprise at least one skip connection from the common input model to the common output model.

In some implementations, the first metrology system and the second metrology system may be the same metrology system, and wherein the target configuration data specify a configuration of the metrology system that is different from the configuration used to generate the metrology data.

In some implementations, the proposed method may be used to iteratively optimize the target configuration data (e.g. over one or iterations). For example, the method may further comprise processing the predicted metrology data to determine one or more performance parameters (e.g. an uncertainty associated with an determined overlay value), processing the one or more performance parameters to generate updated target configuration data (e.g. with updated setting data; for example the updated target configuration data may specify a different (e.g. more suitable) spectral density for inspecting the pattern portion which is likely to have resulted in metrology data from which improved performance parameters could have been obtained (i.e. a reduced uncertainty of the overlay value)), and processing, using the neural network, the metrology data, the configuration data of the first metrology system and the updated target configuration data to generate updated predicted metrology data. This means that improved performance parameters can be obtained from the updated predicted metrology data (i.e. a reduced uncertainty of the overlay value). This may be particularly useful in cases where the first metrology system and the second metrology system may be the same metrology system.

According to a second aspect, there is provided a method of training a neural network (e.g. the neural aspect according to the first aspect) for generating predicted metrology data of a patterned portion of a substrate patterned using a lithographic apparatus. The neural network comprising an input network and an output network, the input network comprising a common input model and a specific input model, wherein specific input model is associated with a first metrology system. The neural network is configured to:

receive metrology data of the patterned portion generated using the first metrology system;
receive configuration data specifying a configuration of the first metrology system used to generate the metrology data;
process, using the common input model and the specific input model, the metrology data and the configuration data to generate an encoding of the patterned portion; and
process, using the output network of the neural network, the encoding of the patterned portion to generate the predicted metrology data, the predicted metrology data being a prediction of metrology data which would have been generated by inspecting the patterned portion using a second metrology system,

In some implementations, the method may comprises obtaining a training dataset comprising first training metrology data generated using the first metrology system, configuration data specifying a configuration of the first metrology system used to generate the first training metrology data, and a second training metrology data generated using the second metrology system, wherein the first and second training metrology data have been generated by inspecting the same patterned portion of a training substrate patterned by the, or a further, lithographic apparatus.

In some implementations, the method may comprises processing, using the common input model and the specific input model, the first training metrology data and the corresponding configuration data to generate an encoding of the patterned portion.

In some implementations, the method may comprises processing, using the output network of the neural network, the encoding of the patterned portion to generate predicted second training metrology data, the predicted second training metrology data being a prediction of metrology data which would have been generated by inspecting the patterned portion using the second metrology system.

In some implementations, the method may comprises updating weights of the neural network to reduce a measure of the discrepancy between the predicted second training metrology data and the second training metrology data.

In some implementations, the input network may comprise a plurality of specific input models, each specific input model being associated with a different respective metrology system of a plurality of metrology systems comprising at least the first and second metrology systems and a third metrology system.

In some implementations, the neural network may be configured to process the metrology data and the configuration data to generate an encoding of the patterned portion by:

processing, using the common input model, the metrology data to generate an encoding of the metrology data; and
processing, using the specific input model of the first metrology system, the encoding of the metrology data and the configuration data to generate the encoding of the patterned portion,

wherein the training dataset further comprises third training metrology data generated using the third metrology system, configuration data specifying a configuration of the third metrology system used to generate the third training metrology data, and fourth training metrology data generated using the second metrology system, wherein the third and fourth training metrology data have been generated by inspecting the same patterned portion of a respective training substrate patterned by the, or a further, lithographic apparatus;
the method further comprising:

processing, using the common input model, the third training metrology data to generate an encoding of the third training metrology data; and
processing, using the specific input model of the third metrology system, the encoding of the third training metrology data and the corresponding configuration data of the third metrology system to generate the encoding of the patterned portion,
processing, using the output network of the neural network, the encoding of the patterned portion to generate predicted fourth training metrology data, the predicted fourth training metrology data being a prediction of metrology data which would have been generated by inspecting the patterned portion using the second metrology system; and
updating weights of the neural network to reduce:
a measure of discrepancy between the predicted fourth training metrology data and the fourth training metrology data.

In some implementations, the output network may comprise a common output model and a plurality of specific output models, each specific output model associated with a different metrology system of the plurality of metrology systems, wherein the neural network is configured to process the encoding of the patterned portion to generate the predicted metrology data by:

processing, using the specific output model of the second metrology system, the encoding of the patterned portion and target configuration data to generate the encoding of the predicted metrology data; and
processing, using the common output model, the encoding of the predicted metrology data portion to generate the predicted metrology data,
wherein the training dataset further comprises fifth training metrology data generated using the first metrology system, configuration data specifying a configuration of the first metrology system used to generate the fifth training metrology data, a sixth training metrology data generated using the third metrology system, and configuration data specifying a configuration of the third metrology system used to generate the sixth training metrology data, wherein the fifth and sixth training metrology data have been generated by inspecting the same patterned portion of a respective training substrate patterned by the, or a further, lithographic apparatus;

the method further comprising:

processing, using the common input model, the fifth training metrology data to generate an encoding of the fifth training metrology data; and
processing, using the specific input model of the first metrology system, the encoding of the fifth training metrology data and the corresponding configuration data of the first metrology system to generate an encoding of the patterned portion,
processing, using the specific output model of the third metrology system, the encoding of the patterned portion and the corresponding configuration data of the third metrology system to generate an encoding of predicted sixth training metrology data; and
processing, using the common output model, the encoding of the predicted sixth metrology data to generate the predicted sixth training metrology data,
updating weights of the neural network to reduce:
a measure of discrepancy between the predicted sixth training metrology data and the sixth training metrology data.

In some implementations, the first metrology system and the third metrology system may be the same metrology system, and the corresponding configuration data may specify the same configuration of the metrology system. Such training may improve the neural network (in particular the specific models) because it encourages self-consistency.

In some implementations, the plurality of metrology systems may comprise at least one simulated metrology system.

According to a third aspect, there is provided a computer program product comprising machine-readable instructions which, when the program is executed by a computer, cause the computer to carry out the method of any preceding aspect.

According to a fourth aspect, there is provided a computer system comprising a processor and a data storage device, the data storage device storing program instructions which, when executed by the processor, cause the processor to carry out the method of the first or the second aspect.

BRIEF DESCRIPTION OF THE DRAWINGS

Embodiments of the invention will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 depicts a schematic of an example neural network which is an embodiment of the invention;
- Figure 5 depicts a flow diagram of an example process for generating predicted metrology data using the neural network of Figure 4;
- Figure 6 depicts a schematic of a training system for training the neural network of Figure 4;
- Figure 7 illustrates the training the neural network of Figure 4;
- Figures 8 and 9 further illustrate the training the neural network of Figure 4;
- Figures 10 to 12 depict schematics of further example neural networks which are embodiments of the invention, and
- Figures 13 to 17 depict experimental data.

DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultraviolet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

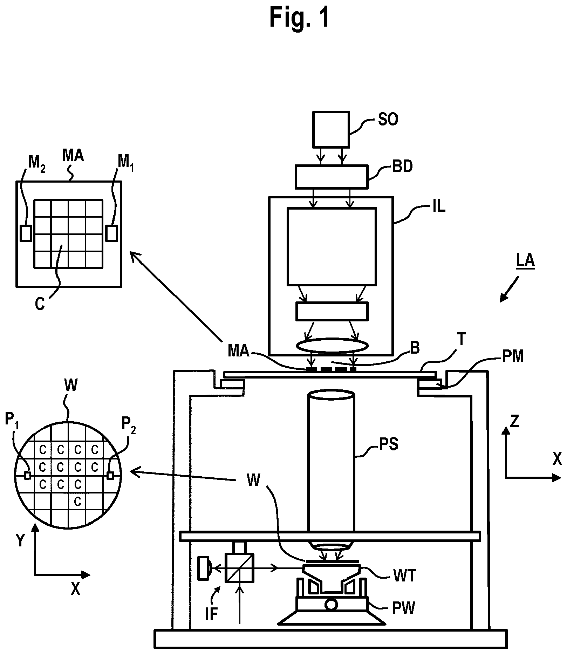

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

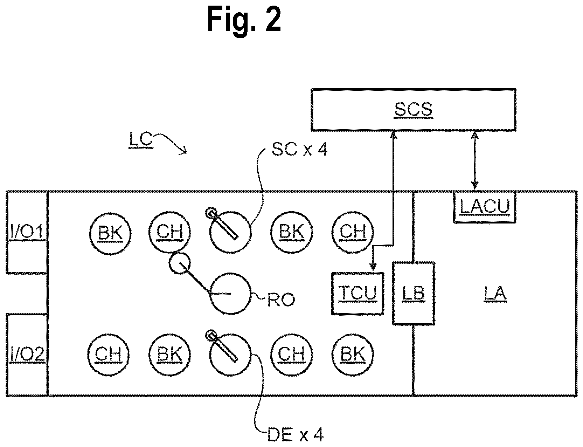

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

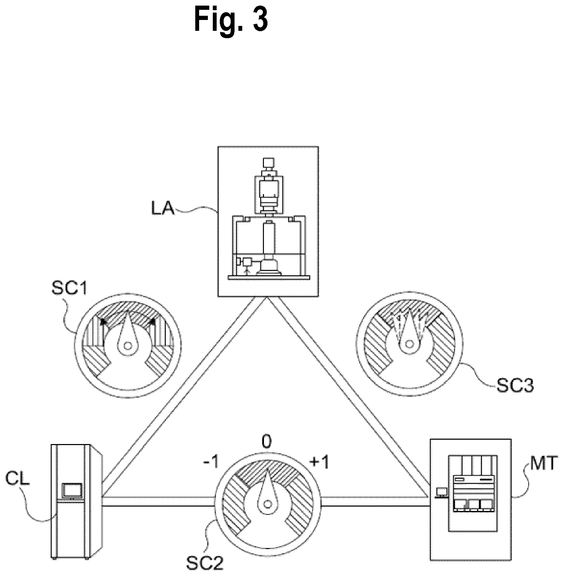

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

It is often desirable to inspect the patterned substrate using a metrology system, e.g. to determine whether the patterned substrate was fabricated correctly, and/or whether the lithographic apparatus is operating correctly or needs adjusting. The term metrology system (or just "tool" for short hereafter) may refer to any suitable instrument that is capable of determining relevant properties of the patterned substrate. Examples of metrology systems include image-based metrology instruments (e.g. micro diffraction based overlay metrology (uDBO) instruments, phase based overlay metrology (pDBO) instruments, optical dark-field microscopes and the like), pupil-based metrology instruments (e.g. scatterometers, soft x-ray metrology instruments), scanning electron microscopes (e.g. single beam or multi-beam SEMs), and the like.

As noted above, in practice, different instances of the same type of metrology system generate, for the same target, metrology data which differ from each other in one or more aspects. Such "tool-mismatch" can occur for different reasons. As a first example, tool-mismatch between single-beam SEMs may be caused by tool-to-tool variations of the scanning beam angle, the contrast, the noise level, and so forth. As a second example, in a multi-beam SEM system (which can have an array of 9 to 2800 electron beams), images produced by different electron beams may vary because the design of the system may inherently result in variations between the electron beams (i.e. in a multi-beam SEM, each electron beam may be considered to be an individual metrology system). For instance, electron beam aberrations may be stronger for electron beams located away from the centre of the beam array than for those near the centre. Hardware-based solutions for reducing electron beam variations (e.g. by tight hardware specifications or by modifications to specific hardware elements) are often undesirable (e.g. costly, problematic to adapt when further beam-to-beam variations occur due to aging of the system, and so forth). As a third example, tool-mismatch between image-based metrology instruments (e.g. uDBO, or continuous bias DBO (cDBO)) used for inspecting scribe lane targets (i.e. targets positioned in areas between semiconductor dies) may be caused by tool-induced asymmetries, biases, image distortions and inter/intra pad cross-talk. As a fourth example, tool-mismatch between pupil-based metrology instruments (e.g. scatterometers using soft x-ray and/or visible to near-IR light) may be caused by tool-dependent optical aberrations that corrupt the generated signal and can introduce tool-induced biases.

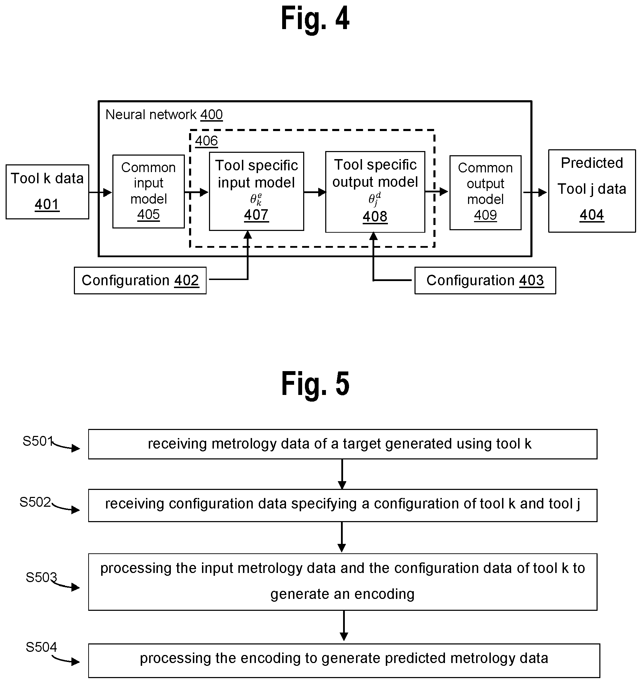

Figure 4 shows a neural network 400 which, once trained, can process input metrology data of a target generated using a first metrology system (denoted tool k, where "k" is an index that identifies the first metrology system from a plurality of N metrology systems of the same type (i.e. $k \in 1 \ldots N$)) to generate a prediction of metrology data which would have been generated by inspecting the same target using a second metrology system (denoted tool j, $j \in 1 \ldots N$). Thus, using the neural network 400, metrology data acquired using tool k can effectively be "mapped" to metrology data acquired using the tool j (thus, the neural network 400 may be considered to implement a "tool-to-tool" mapping, e.g. a tool k to tool j mapping). The mapped metrology data can then be compared to other metrology data generated using tool j (e.g. metrology data of other targets) without the aforementioned tool-mismatch issues.

More specifically, the neural network 400 of Figure 4 is configured to receive, as network input, metrology data 401, configuration data 402, and configuration data 403. The metrology data 401 has been generated by inspecting a target generated using tool k. In the embodiment of Figure 4, the inspection target is a patterned portion of a substrate (e.g. a portion of a semiconductor wafer) patterned using a lithographic apparatus (e.g. the above described lithographic apparatus). Tool k is an instance of a type of a metrology system that is suitable for inspecting the patterned portion (e.g. using image-based metrology, pupil-based metrology, scanning electron microscopy, or the like). The metrology data comprises an array of numerical values specifying aspects of the inspected target. As one example, the metrology data 401 of Figure 1 has been generated using image-based metrology, and the metrology data 401 comprises image data. More specifically, the metrology data 401 that is provided to the neural network 400 may comprise a two-dimensional array of intensity values corresponding to the (raw or pre-processed) image data obtained by an image sensor of tool k. As another example, in implementations where tool k uses pupil-based metrology, tool k may generate metrology data comprising an array of numerical values specifying a pupil representation defining a distribution of radiation in a pupil plane of the tool.

The input configuration data 402 include "immutable" data defining a type of the first metrology system. (e.g. data defining a manufacturer of the first metrology system, and/or model type), and/or setting data to specify a configuration of tool k during the acquisition of the metrology data 401. The input configuration data 402 may specify the configuration of tool k in any suitable way (the specified configuration of tool k may be an estimated configuration of tool k). As one example, the input configuration data 402 may comprise setting data specifying operating parameters of the tool k (e.g. exposure time, scanning speed, a spectral density of light used to inspect the target, and the like). The operating parameters may comprise parameters set by a user of the tool before using the tool. As another example, the input configuration data 402 may be an estimate of the configuration of tool k (as discussed below, in some examples of the use of the present system, there may be at least one step of improving this estimate based on the output of the neural network 400, e.g. iteratively). As another example, the input configuration data 402 may comprise reference metrology data to define the configuration of tool k indirectly. The reference metrology data may be metrology data of a reference target generated using the tool k configured in the same configuration as used to generate the metrology data 401. As described below, in this case, the neural network 400 may also be configured to determine the operating parameters of the tool k from the reference metrology data.

The configuration data 403 specifies a configuration of tool j in a similar way in which the configuration data 402 specifies the configuration of tool k.

The neural network 400 is configured to process the metrology data 401, the configuration data 402, and the configuration data 403 to generate predicted metrology data 404. The predicted metrology data 404 is a prediction of metrology data which would have been generated by inspecting the target (i.e. the same target for which the input metrology data 401 have been generated) using tool j configured according to the configuration specified in the configuration data 403. In general, tool j may be a different instance of the metrology system (e.g. a different apparatus or a different electron beam in case of a multi-beam SEM) or tool j may be the same instance as tool k but, for example, in a different configuration (i.e. the configurations specified in the configuration data 402, 403 are different).

To achieve the aforementioned tool-to-tool mapping, a neural network comprising an encoder-decoder architecture may be used (i.e. a variation of the known autoencoder architecture). Such an encoder-decoder architecture may comprise an encoder for generating data in a latent space and a decoder. The encoder is configured to compress input data into a (typically lower dimensional) latent space representation, and then the decoder (instead of being configured to reconstruct the original input) may be configured to predict a modified version of the original input from the encoded data (i.e. from the latent space representation). Thus, a neural network for tool-to-tool mapping may comprise an encoder-decoder architecture. In this case, the encoder-decoder architecture may be used to encode the input metrology data and the input configuration data into a latent space representation and generate the desired predicted metrology data from the latent representation and the configuration data. The inventors have realized that a problem with this network architecture is that the training of such a network is resource-inefficient, in particular when multiple networks are to be trained, e.g. to enable mapping in both directions (e.g. one network for mapping tool k to tool j, and one network for mapping tool j to tool k), or when the "fleet" of metrology systems is large (N>2). For example, to implement a specific tool mapping (say tool j to tool k) the entire network needs to be trained without benefiting from a previously trained network that implements a different mapping within the fleet (say tool k to tool j).

The inventors realized that it is advantageous to employ a network architecture in which the encoding is split into multiple stages which include a stage that is implemented by a (large) model that is "common" (i.e. a model that can be (re-) used for any mapping within the plurality of N metrological systems) and a stage that is implemented by a (small) model that is "tool-specific" (i.e. a model that can be used for any mapping that maps the tool associated with the tool-specific model to another of the N metrological systems). Here "small" may refer to the number of trained numerical parameters, e.g. the tool-specific model has fewer trained numerical parameters than the common model. Similarly, the decoding stage may also be split into "common" and "tool-specific" models. As described in more detail further below, the proposed architecture reduces the resources needed to train networks that implement new mappings within the N metrological systems, and makes it possible to the use any combination of data pairs, coming from two metrological systems, thereby reducing the number of measurements needed.

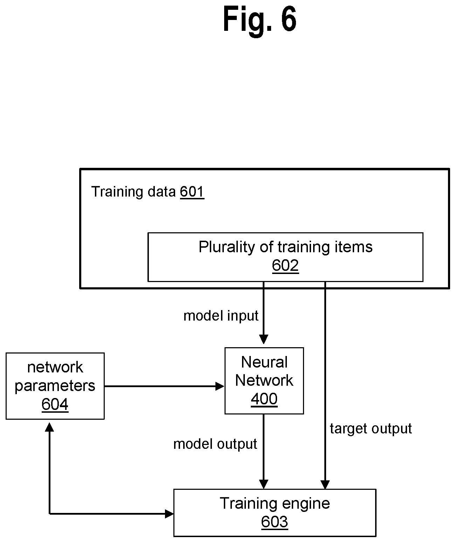

The neural network 400 of Figure 4 is an example of a neural network that implements the above described concept of using common and tool-specific models. More specifically, neural network 400 comprises a common input model 405, a tool re-mapping section 406 comprising a tool-specific input model 407 and tool-specific output model 408, and common output model 409. The common input model 405 is configured to process the metrology data 401 to generate an encoding of the metrology data (the generated encoding is typically lower dimensional than the metrology data 401). The common input model 405 is defined by a plurality of learnable network parameters (denoted "E") which values have been obtained by a training process in which the common input model 405 is presented with metrology data from multiple (e.g. all) of the N tools (i.e. not only data from tool k), as further described below with reference to Figures 6 to 8. In broad terms, because the common input model 405 has been trained using data generated from different tools, the common input model 405 has learned to disentangle effects that are common to the tools and effects that are tool-specific. The tool-specific input model 407 is configured to process the encoding generated by the common input model 405 and the input configuration data 402 to generate an encoding of the patterned portion. The tool-specific input model 407 is specific to tool k, i.e. the tool-specific input model 407 is defined by a plurality of learnable network parameters (denoted "$\theta_k^e$") which values have been obtained by a process in which a "tool k to tool i" mapping is implemented (where "tool i" denotes any one of the N tools). In broad terms, the tool-specific input model 407 generates the encoding of the patterned portion so that information specifying aspects of the metrology data 401 which are specific to tool k is removed. For example, the tool-specific input model 407 may generate the encoding of the patterned portion so as to remove information specifying aberrations of tool k.

Note that in principle the tool-specific input model 407 might be trained in a training process which starts from an initial state (a starting realization of its trainable parameters) which was obtained by a training process in which, during the training, the input model encoded data from tools other than k. However, the final version of its numerical parameters was obtained in a training process in which, in multiple successive learning iterations, it only encoded training data obtained from tool k.

The tool-specific output model 408 is configured to process the encoding generated by the tool-specific output model 407 and the configuration data 403 to generate an encoding of the predicted metrology data. The tool-specific output model 408 is specific to tool j, i.e. the tool-specific output model 408 is defined by a plurality of learnable network parameters (denoted "$\theta_j^d$") which values have been obtained by a process in which a "tool i to tool j" mapping is implemented (i.e. any tool to tool j). In other words, the final version of the numerical parameters of the tool-specific output model 408 was obtained in a training process in which (irrespective of the initial state of the tool-specific output model), in multiple successive learning iterations, it only predicted training data obtained from tool j. In broad terms, the tool-specific output model 408 generates the encoding of the predicted metrology data 404 so as to add information specifying aspects which are specific to tool j. For example, the tool-specific output model 408 may generate the encoding of the predicted metrology data so as to incorporate information specifying aberrations of tool j.

The common output model 409 is configured to process the encoding of the predicted metrology data to generate the predicted metrology data 404. Similar to the common input model 405, the common output model 409 is defined by a plurality of learnable network parameters (denoted "D") which values have been obtained by a training process in which the common output model 409 generates predicted metrology data for multiple (e.g. all) of the N tools (i.e. not only for tool j), as further described below with reference to Figures 6 to 8.

The common input model 405, the tool-specific input model 406, the tool-specific output model 407 and the common output model 409 can have any suitable architecture and can include, e.g., one or more convolutional neural network layers. In some embodiments, the neural network 400 may be implement as U-Net architecture.

The common input model 405 may be a larger model than the tool-specific input model 406 (e.g. the number of learnable parameters of the common input model $E$ may be larger (e.g. at least 10 times larger) than the number of learnable parameters of the tool-specific input model $\theta_k^e$). Similarly, the common output model 409 may be a larger model than the tool-specific output model 407 (e.g. the number of learnable parameters of the common input model $D$ may be larger (e.g. at least 10 times larger) than the number of learnable parameters of the tool-specific input model $\theta_j^d$).

While the neural network 400 has been described as comprising a common input model for processing the input metrology data and a tool-specific input model for processing the output of the common input model, it is to be understood that in other embodiments, the order of common and tool-specific models may be reversed, i.e. the tool-specific input model may be configured to process the input metrology data, and the common input model may be configured to process the output of the tool-specific input model. Similarly, in some embodiments, the order of the tool-specific output model and the common output model may be reversed, i.e. the common output model may process the encoding of the pattern portion and the tool-specific output model may process the output of the common output model.

While the neural network 400 has been described as receiving configuration data 402, in other embodiments, the neural network 400 may not directly receive configuration data 402 but may implicitly or explicitly infer the configuration data from the metrology data 401. In this case, the metrology data 401 may comprise data of the same target under multiple conditions (e.g. wafer rotation mode). In this case, the neural network may be configured to process the multiple measurements to implement a multi-channel to multi-channel mapping. Alternatively, neural network may be configured to process each of the multi-condition acquisitions separately and determine the configuration data from the acquisitions.

An example process for generating predicted metrology data using the (trained) neural network 400 of Figure 4 is described with reference to Figure 5. In broad terms, a typical scenario in which the process of Figure 5 is applied may be that a substrate is patterned by a lithographic apparatus as part of a manufacturing process, and, once the patterning is completed, the substrate is transferred so that tool k and tool j can inspect (in parallel or sequentially) different (possibly overlapping) portions of the newly patterned substrate. The process of Figure 5 is then performed to achieve a "tool k to tool j" mapping of the metrology data generated by tool k. The mapped metrology data (and optionally and the metrology data generated by tool j) can then be further processed using known algorithm without being affected by tool-mismatch. For example, a person wishing to diagnose a fault in a substrate inspected using tool j, can map metrology data collected using tool j to data generated tool k, and then analyse the result using diagnostic algorithms developed for, e.g. calibrated with reference to, tool k.

In an initial step S501, metrology data 401 of the patterned portion generated using tool k is received. In step S502, configuration data 402 specifying the configuration of tool k during acquisition of the metrology data 401 and configuration data 403 specifying a configuration of tool j are received. In step S403, the common input model 405 processes the metrology data 401 to generate an encoding of the metrology data. Then, the tool-specific input model 407 processes the encoding of the metrology data to generate an encoding (or "latent representation") of the patterned portion. In step S504, the encoding of the patterned portion is processed to generate the predicted metrology data 404 (so that the predicted metrology data 404 is a prediction of metrology data which would have been generated by inspecting of the patterned portion using tool j configured according to the configuration specified in the configuration data 403). More specifically, the tool-specific output model 408 processes the encoding of the patterned portion and the configuration data 403 of tool j to generate an encoding of the predicted metrology data. Then, the common output model 409 processes the encoding of the predicted metrology data to generate the predicted metrology data 404.

A training system for training the neural network 400 is now described with reference to Figure 6. The training system comprises training data 601 comprising a plurality of training items 602. The training data 601 is used together with a training engine 603 to iteratively update/optimise the values of a plurality of parameters 604 defining the neural network 400.

Each training item may be associated with a pair of tools and comprise corresponding training metrology and configuration data. For example, training items associated with a tools k and j comprise training metrology data (denoted $m_k$) generated using tool k, configuration data of tool k, training metrology data (denoted $m_j$) generated using tool j, and configuration data of tool j. The training metrology data belonging to the same training item have been generated by inspecting the same target (e.g. patterned portion).

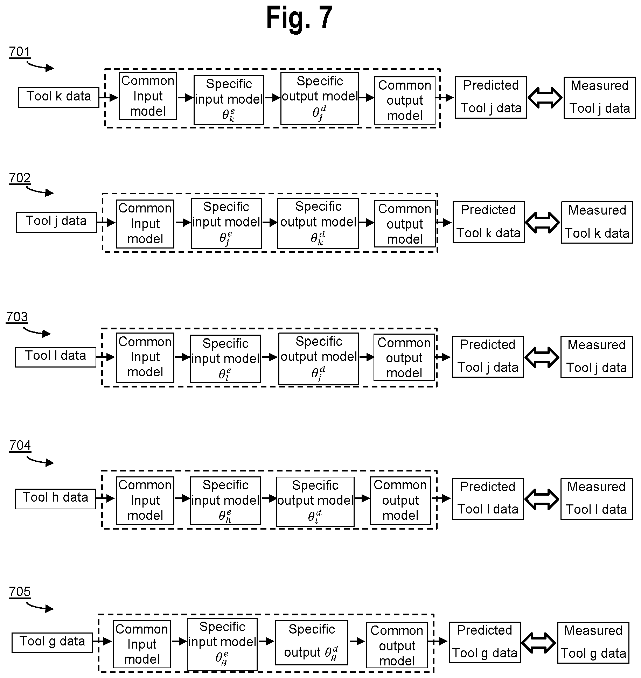

The plurality of training items may be used to train, over a plurality of iterations, the common input model, the common output model, as well as tool-specific input and output models for each of the N tools. In each iteration, an update for the parameters 604 is generated by processing a training item. Figure 7 illustrates training iterations in which training items associated with different tools are processed. Iteration 701 illustrates the case for a training item associated with tools k and j. The training metrology data generated using tool k, the configuration data of tool k, and the configuration data of tool j are processed using the neural network 400 (as described above with reference to Figures 4 and 5) to generate predicted training metrology data. This may be expressed as

$$M\left(m_k, E, D, \theta_k^e, \theta_j^d\right) \to p_j$$

where M(...) denotes the neural network 400, $p_j$ denotes the predicted training metrology data (the configuration data are omitted for clarity). The training metrology data generated using tool j and the predicted training metrology data are then processed by the training engine 603 to generate an update for the parameters 604. This generally involves backpropagating gradients of an objective function to update the learnable parameters $E, D, \theta_k^e, \theta_j^d$ using any appropriate gradient descent optimization algorithm, e.g. Adam or another optimization algorithm. Generally, the parameters $E, D, \theta_k^e, \theta_j^d$ may be updated to reduce a discrepancy (or mismatch) between the input training metrology data $m_k$ and the predicted training metrology data $p_j$.

As illustrated in iteration 702, the same training item as used in iteration 701 can be reused to further train the neural network by reversing the role of the metrology data $m_k$ and $m_j$. In this case, a tool-specific input model for tool j (defined by parameters $\theta_j^e$) is used to process the output of the common input model, and a tool-specific output model for tool k (defined by parameters $\theta_k^d$) is used to process the process the encoding of the patterned portion. Thus, in iteration 702, training metrology data generated using tool j, configuration data of tool j, and configuration data of tool k are processed to generate the predicted training metrology data for the respective iteration. Similar to iteration 701, the training engine may update the learnable parameters $E, D, \theta_j^e, \theta_k^d$ based on the predicted training metrology data and the metrology data generated using tool k.

Iteration 703 illustrates an iteration where a training item associated with tool l and tool j is processed using a corresponding tool-specific input model for tool l (defined by parameters $\theta_l^e$) and the tool-specific output model for tool j. Iteration 704 illustrates an iteration where a training item associated with tool h and tool l is processed using a corresponding tool-specific input model for tool h (defined by parameters $\theta_h^e$) and the tool-specific output model for tool l (defined by parameters $\theta_l^d$). Iteration 705 illustrates an iteration in which the training item is only associated with one tool (here tool g). In this case, the tool-specific input model and the tool-specific output model are both specific to tool g, and the neural network attempts to reconstruct the input metrology data $m_g$.

After performing the plurality of training iterations, the training system may update the parameters $E, D,$ $\theta_i^e, \theta_j^d$ (for all $i, j \in 1 \ldots . N$) to optimize a cost function,

$$\arg \min_{E,D,\theta_i^e,\theta_i^d} \sum_{i,j} C\left(M\left(m_i, E, D, \theta_i^e, \theta_j^d\right) - m_j\right),$$

where $C(\ldots)$ is a data distance term (i.e. $C\left(M\left(m_i, E, D, \theta_i^e, \theta_j^d\right) - m_j\right)$ is a cost term that penalizes any difference between $m_j$ and the prediction M.

In some implementations, a variational inference scheme may be employed, i.e. parameters $\theta_i^e$ and $\theta_j^d$ may be sampled from a distribution regularized using Kullback-Leibler (KL) divergence priors. In this case, the distribution modes (e.g. mean and valiance for each $\theta$) may be modeled with a value resulting from drawing a sample from the distribution. To this end, a regularization term $r(\cdot)$ may be included in the cost function, e.g. in some implementations, the cost function may read

$$\arg \min_{E,D,\theta_i^e,\theta_i^d} \sum_{i,j} C\left(M\left(m_i, E, D, \theta_i^e, \theta_j^d\right) - m_j\right) + r(\cdot) .$$

The illustrated training of the proposed neural network is resource-efficient due the novel architecture of network. As one example, the architecture of the proposed neural network enables

using training data from the entire population of tools. As another example, an instance of the neural network 400 may be trained to implement a mapping within the N tools, say tool k to tool h, without having access to corresponding training items (i.e. without requiring tool k and tool h to measure the same target).

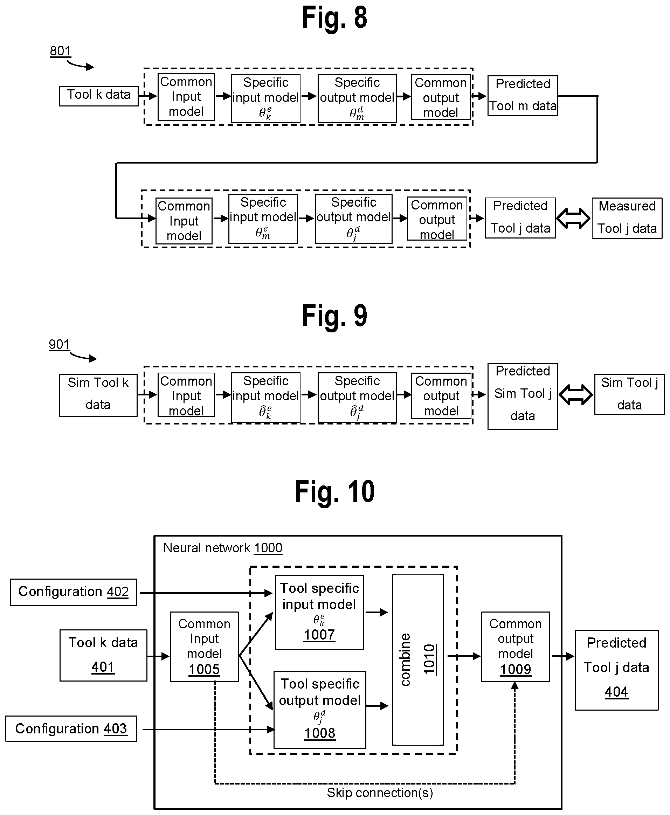

Another advantage of the proposed neural network is that new tools can be added by simply training the corresponding specific input and out models. As mentioned above, the specific input and out models may be smaller than the common input and output models, and may be trained using only a few training items. Further, new tools may even be added without requiring to measure "old" targets (i.e. target which have been measured by one or more of the N tools) with the new tool. This may be achieved by performing a "two-pass" process, as illustrated in Figure 8. In the training iteration 801 of Figure 8, a training item associated with tool k and tool j is used to train the specific input and output models for the new tool m. To this end, metrology data generated by tool k is processed to generate predicted metrology data for tool m. The predicted metrology data for tool m is then processed to generate predicted metrology data for tool j which can be compared to metrology data generated by tool j.

The "two-pass" training process illustrated in Figure 8 may also be used to add simulated tools to the plurality of tools, i.e. the process of Figure 8 may be used to train corresponding tool-specific input and output models for the simulated tool. A simulated tool may refer to a computational model (i.e. and not to a real-world device) that generates simulated metrology data. A simulated tool may by comprise physics-based models (e.g. sets of differential equations modelling the imaging process). Adding simulated tools enables transferring domain knowledge (e.g. knowledge of the physics underlying the inspection process) into models to the neural network. In some cases, a simulated tool may represent an "ideal" tool, e.g. a metrology system without aberrations.

In addition or alternative to the two-pass" training process illustrated in Figure 8, simulated tools may be trained using training items associated with pairs of simulated tools (i.e. training items comprising pairs of simulated metrology data (and respective configuration data). For example, Figure 9 illustrates the case where a training item associated with simulated tool k and simulated tool j is processed using a corresponding tool-specific input model for simulated tool k (defined by parameters $\hat{\theta}_k^e$ ) and the tool-specific output model for simulated tool j (defined by parameters $\hat{\theta}_j^d$ ). In this case, the training system may generate parameter updates of a cost function that reads

$$\arg \min_{E,D,\theta_i^e,\theta_i^d,\hat{\theta}_i^e,\hat{\theta}_i^d} \sum_{i,j} C\left(M\left(m_i, E, D, \theta_i^e, \theta_j^d\right) - m_j\right) + + \sum_{i,j} C\left(M_s\left(m_i, E, D, \hat{\theta}_i^e, \hat{\theta}_j^d\right) - m_j\right) + r(\cdot) .$$

Advantageously, both the process of Figure 8 and the process of Figure 9 avoid a need to compare simulated metrology data directly with measured metrology data.

With reference to Figure 10, a variation of the proposed neural network will now be described. The neural network 1000 is generally similar to the neural network 400 of Figure 4, in particular in that the neural network 1000 is configured to process the metrology data 401, the configuration data 402, and the configuration data 403 to generate predicted metrology data 404. As before, the predicted metrology data 404 is a prediction of metrology data which would have been generated by inspecting the target (i.e. the same target for which the input metrology data 401 have been generated) using tool j configured according to the configuration specified in the configuration data 403. The neural network 1000 comprises a common input model 1005, a tool-specific input model 1007, a tool-specific output model 1008, a common output model 1009 , and a combiner module 1010. The common input model 1005 is configured to process the metrology data 401 to generate an encoding of the metrology data. The tool-specific input model 1007 is configured to process the encoding of the metrology data and the configuration data 402 to generate first encoded data. The tool-specific output model 1008 is configured to process the encoding of the metrology data and the configuration data 403 to generate second encoded data. The combiner module 1010 is configured to combine the first and second encoded data to generate the encoding of the patterned portion. Many ways of combining the first and second encoded data to generate the encoding of the patterned portion exist. For example, the combiner module 1010 may be configured to combine the first and second encoded data by concatenating the first and second encoded data. Similar to the common output model 409 of Figure 4, the common output model 1009 is configured to process the encoding of the patterned portion to generate the predicted metrology data.

Optionally, the neural network 1000 may comprise one or more skip connections. More specifically, the neural network 1000 may comprise one or more skip connections from the common input model 1005 to the common output model 1009 (i.e. the output of the common input model 1005 is fed into the common output model 1009).

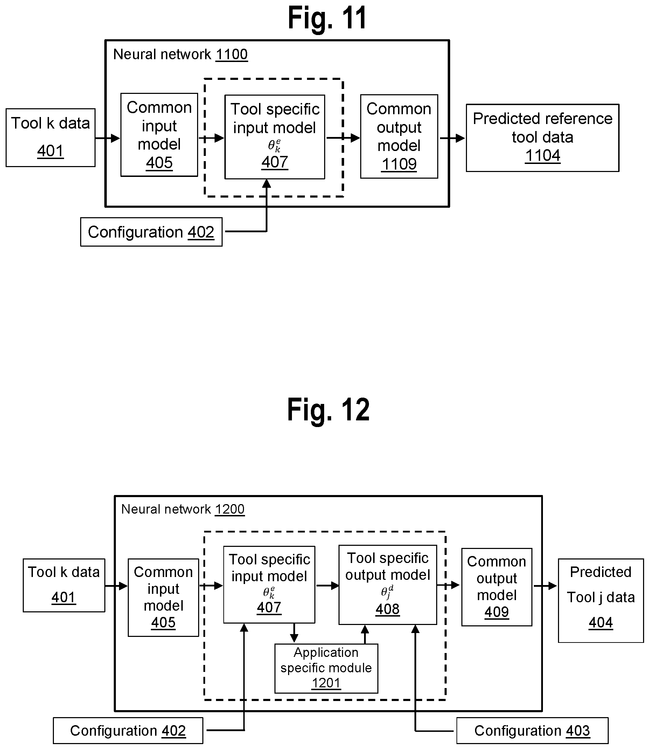

A further variation of the proposed neural network will now be described with reference to Figure 11. The neural network 1100 of Figure 11 has a simpler architecture than the neural network 400 and may be used in cases where all tools are to be mapped to the same reference tool (for example, when the N tools are N beams of a multi-beam SEM, mapping all beams to one reference beam may be desirable). The "reference tool" may be a real-world tool, a simulated tool or an "average" tool of the population of the N tools. In implementations in which the reference tool is the "average" tool of the population, the neural network may be implemented using variational models and a realistic "average" tool may be the determined from most likely sample out of the distribution used as priors for the variational sampling.

Since all tools are to be mapped to the same reference tool, the tool-specific output model is not needed (or can be incorporated into the common output model). More specifically, the neural network 1100 of Figure 11 is generally similar to the neural network 400 of Figure 4, except that the neural network 1100 does not include the tool-specific output model 408 and does not receive the configuration data 403. Similar to the neural network 400, the metrology data 401 and the configuration data 402 are processed by the common input model 405 and the tool-specific input model 407. The common output model 1109 of the neural network 1100 is configured processes the output of the tool-specific input model 407 to generate the predicted metrology data 1104. The predicted metrology data 1104 is a prediction of metrology data which would have been generated by inspecting the target (i.e. the same target for which the input metrology data 401 have been generated) using the reference tool configured according to a "fixed" configuration. A further variation of the proposed neural network will now be described with reference to Figure 12. The neural network 1200 is identical to the neural network 400 of Figure 4, except that the neural network 1200 further comprises a trained application-specific model 1201. The application-specific model 1201 is specific to an application type (i.e. a specification of a type of the patterned substrate used to produce the tool k data 401, e.g. a particular uDBO target design), from a set of application types (e.g. a set of uDBO target designs). The application specific model 1201 assists the neural network 1200 in generating predicted tool j data 404 for this application. Note that the purpose of the application specific model 1201 is not to translate between different applications; rather, the input tool k data 401 and the predicted tool j data 404 both relate to the same application (patterned substrate type). In particular, the application-specific model 1201 is specific to an application type associated with the patterned portion of the input metrology data 401 which means that the application-specific model 1201 has been trained only on training metrology data of the corresponding application type (i.e. patterns substrates produced according to the application). In embodiments, the neural network may use a training dataset comprising metrology data associated with different applications to train a plurality of application-specific models (each specific to a different application) similar to the above described training of the plurality of specific-input/output models. The use of application-specific models enables the neural network 1200 to be easily trainable across multiple applications (e.g. across multiple uDBO target designs).

More specifically, the application model 1201 is configured to process data from the tool-specific input model based on an application type, from a set of application types, associated with the patterned portion, and to provide the processed data to the tool-specific output model. The tool-specific output model processes the output data of the tool-specific input model and the output data of the application model 1201. The output of the tool-specific output model is processed by the common output model as described above with reference to Figure 4. Thus, because the application model 1201 takes application specific effects into account, the architecture of neural network 1200 removes the necessity to collect training data for a particular application (i.e. a particular target design) from multiple tools.

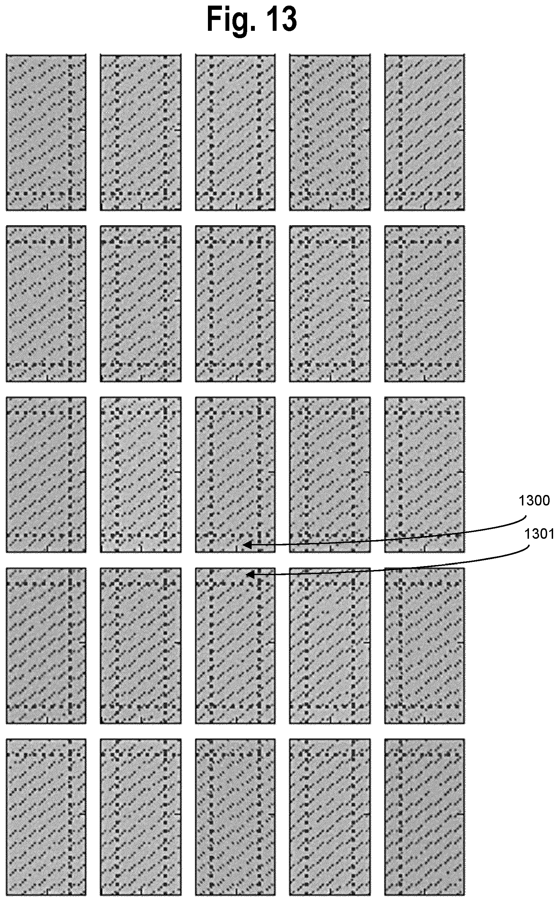

With reference to Figures 13 to 18, experimental data obtained by using a first and a second example implementation of the neural network 1000 of Figure 10 will now be described. Both example implementations of the neural network 1000 are implemented having a U-Net architecture with skip connections between the common input model and the common output model. Both example implementations are fully convolutional with the tool-specific input and output model being also formed by convolutional layers.

Figures 13 to 15 illustrate aberration correction for a multi-beam SEM having an array of 5x5 electron beams which is used to inspect a portion of a substrate that includes a repetitive pattern of a contact array. Figure 13 shows an array of 5x5 panels which show synthetic (i.e. simulated) images "generated" by the multi-beam SEM. As indicated by the dashed lines in Figure 13, nearby beams overlap in terms of measured area. For example, the reference numerals 1300 and 1301 indicate an overlap area between two beams. The overlap areas can be used as to form training items.

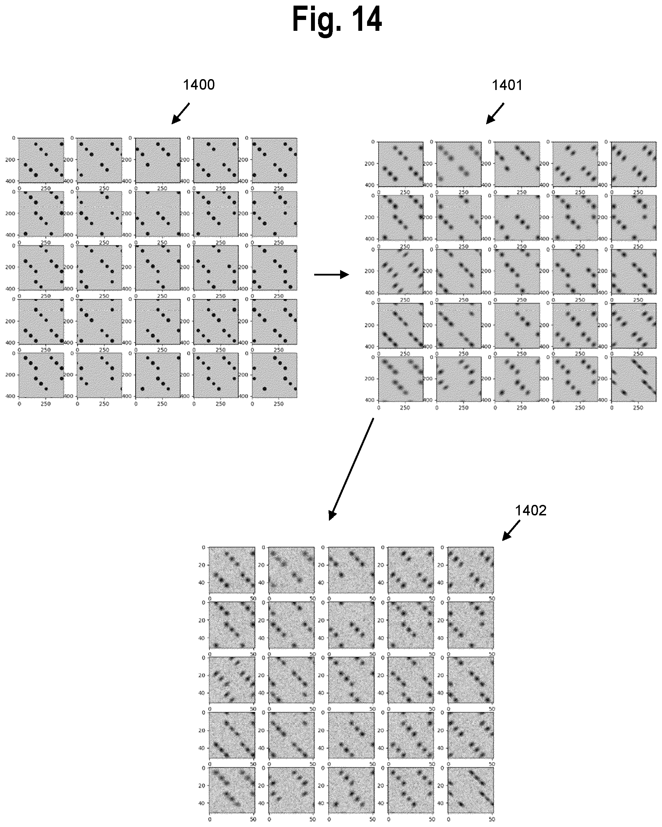

Figure 14 illustrates the generation of the synthetic SEM images of Figure 13. Panel 1400 shows the "ideal" pattern of a contact array where, to simulate defects, CD variability and a probability of missing contacts have been included. Then aberrations are added by modelling each beam as a Gaussian convolution with a different covariance matrix (panel 1401). Finally, the noise is added and the images are down-sampled (panel 1402). In this example application, the aim is to correct beam aberration towards the properties of a single beam, namely the center beam (because the center beam is considered to have the best properties).

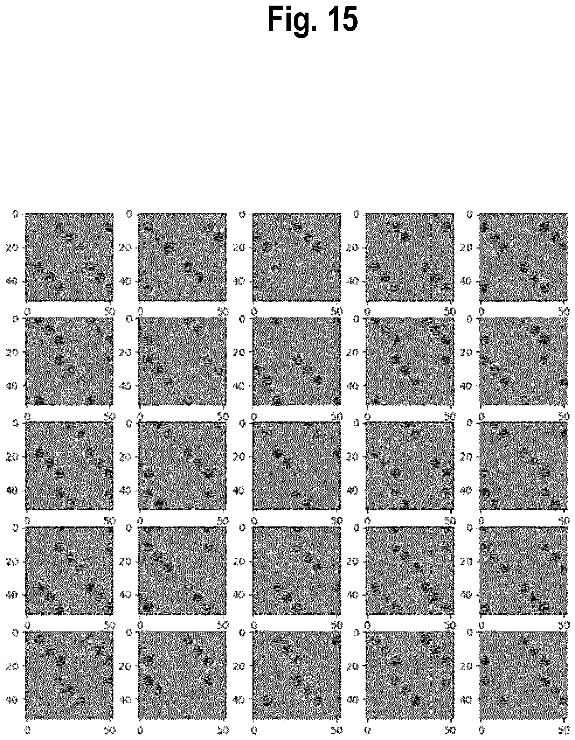

The first example implementation of the neural network 1000 has 5 convolution layers with 16 filters of size 5x5 for both of the common input model and the common input model. Two skip connections corresponding to the second and forth layer outputs are implemented. Before the skip connections a stride of 2 is used, and otherwise a stride of 1. To map the 24 beams towards the center beam, 24 tool-specific input models are implemented. Each tool-specific input model is implemented by a single convolution layer with the same configuration added over the lowest representation layer in the U-Net. This layer is specific to a particular beam while the encoder decoder U-Net layers are shared across all beams. Figure 15 shows the predicted data generated by the first example implementation when all other beams are mapped towards the center beam. Comparing the panel of Figure 15 to the ground truth of panel 1400 of Figure 14, it can be seen that the pattern of a contact array is faithfully reproduced by the neural network. Further, comparing the panel of Figure 15 to the input data of panel 1402 of Figure 14, it can be seen that the neural network successfully removed the tool mismatch (i.e. the different images of Figure 15 show a similar amount of aberrations while the aberrations in the images of panel 1402 vary strongly).

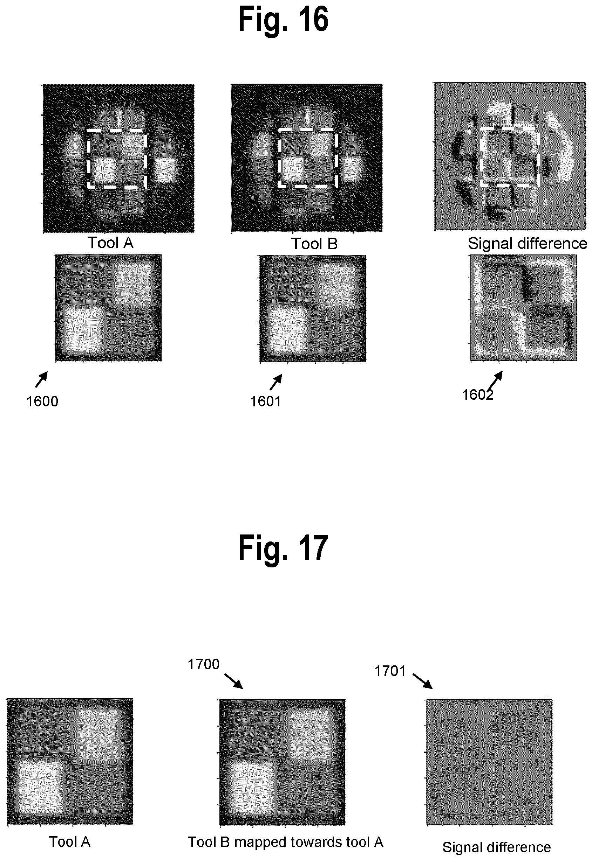

With reference to Figures 16 to 17, experimental data is shown which was obtained by using the second example implementation of the proposed neural network 1000 on uDBO images.

To obtain training and validation, 60 targets have been measured with each of 6 tools and for a nominal focus setting (in both wafer rotation modes and normal) and for complementary acquisition settings. The data set also includes data from 10 targets measured using 5 focus offsets: $\pm 0.6$, $\pm 0.3$, 0 nm. All measured images have been pre-registered. Figure 16 shows uDBO images 1600, 1601 from two different tools (tool A and tool B) as well as the difference between these images 1602. The strong difference signal 1602 indicates strong tool mismatch.

The second example implementation of the neural network includes 10 convolution layers with 32 filters of size 7 $\times$ 7 for the common input model and common output model. Two skip connections corresponding to the third and sixth layer outputs are implemented. Before the skip connections a stride of 2 is used, and otherwise a stride of 1. The common input/output models have a residual network structure for the U-Net blocks, with the residual connections corresponding with the skip connection locations. The tool-specific input/output models each include 3 convolution layers with 16 filters. The input and output of the network have 4 channels, namely for the normal and complementary measurements and for two wafer rotations. The focus level acts as an input to the tool-specific models and is added as a simple bias term after the convolution layers.

55 of the nominal focus targets and 8 of the through focus images have been used for the training (the remaining images have been used for validation). No specific parameter tuning and extensive model size search was performed.

The trained neural network is used to map the image 1601 generated by tool B towards tool A. Figure 17 shows that the mapped image 1700 as well as the difference signal 1701 between the image generated by tool A 1600 and the mapped image 1700. It can be seen that the difference signal is strongly reduced compared to the unmapped signal difference 1602.

Further, a matching improvement is also observed with respect to the overlay. To quantify this, for 5 targets (which have not been used in the training) the overlay spread over tools is obtained, then the mean over these 5 targets is taken. Using a standard overlay extraction algorithm an overlay is determined. When the second example neural network is used to map the images before applying the standard overlay extraction algorithm, then the overlay for the 6 tool is obtained, which is better than the standard overlay matching.

Further embodiments are disclosed in the subsequent numbered clauses:

1. A method of generating, using a neural network, predicted metrology data of a patterned portion of a substrate patterned using a lithographic apparatus, the neural network comprising an input network and an output network, the input network comprising a common input model and a specific input model, wherein the common input model has been trained by a process in which the common input model processes data based on training metrology data generated by a plurality of metrology systems, and the specific input model has been trained by a process in which the specific input model processes data based on training metrology data generated only by a first metrology system, the method comprising:

> receiving metrology data of the patterned portion generated using the first metrology system;
> obtaining configuration data specifying a configuration of the first metrology system used to generate the metrology data;
> processing, using the common input model and the specific input model, the metrology data and the configuration data to generate an encoding of the patterned portion; and
> processing, using the output network of the neural network, the encoding of the patterned portion to generate the predicted metrology data, the predicted metrology data being a prediction of metrology data which would have been generated by inspecting the patterned portion using a second metrology system.

2. The method of clause 1, wherein a first one of the common input model and the specific input model is configured to process the metrology data to generate an encoding of the metrology data, and a second one of the common input model and the specific input model being configured to process the encoding of the metrology data.

3. The method of clause 2 in which the first one of the common input model and the specific input model is the common input model, and the second one of the common input model and the specific input model is the specific input model.

4. The method of clause 2 or 3, wherein processing the metrology data and the configuration data to generate an encoding of the patterned portion comprises:

> processing, using the first one of the common input model and the specific input model, the metrology data to generate an encoding of the metrology data; and
> processing, using the second one of the common input model and the specific input model, the encoding of the metrology data and the configuration data to generate the encoding of the patterned portion.

5. The method of any of clauses 2 to 4, wherein the plurality of metrology systems used in the process to train the common input model comprise the first metrology system, the second metrology system and at least one further metrology system.

6. The method of any preceding clause further comprising a step of obtaining target configuration data specifying a configuration of the second metrology system, and wherein the predicted metrology data is a prediction of metrology data which would have been generated by inspecting the patterned portion using the second metrology system configured according to the target configuration data.

7. The method of clause 6, wherein the output network comprises a common output model trained by a process in which the common output model processes data based on training metrology data generated by a plurality of metrology systems.

8. The method of clause 7, wherein the plurality of metrology systems used in the process to train the common output comprise the first metrology system, the second metrology system and at least one further metrology system.

9. The method of clause 7 or 8, wherein the output network further comprises a specific output model trained by a process in which the specific output model processes data based on training metrology data generated only by the second metrology system.

10. The method of clause 9, wherein a first one of the common output model and the specific output model is configured to process data generated by the input network, and a second one of the common output model and specific output model is configured to process the output of the first one of the common output model and specific output model.

11. The method of clause 10 in which the first one of the common output model and the specific output model is the specific output model, and the second one of the common output model and the specific output model is the common output model.

12. The method of clause 11, wherein processing the encoding of the patterned portion to generate the predicted metrology data comprises:

> processing, using the specific output model, the encoding of the patterned portion and the target configuration data to generate the encoding of the predicted metrology data; and
> processing, using the common output model, the encoding of the predicted metrology data to generate the predicted metrology data.

13. The method of clause 9, wherein processing the metrology data and the configuration data of the first metrology system to generate an encoding of the patterned portion comprises:

processing, using the common input model, the metrology data to generate an encoding of the metrology data;
processing, using the specific input model, the encoding of the metrology data and the configuration data of the first metrology system to generate first encoded data;
processing, using the specific output model, the encoding of the metrology data and the target configuration data to generate second encoded data; and
combining the first and second encoded data to generate the encoding of the patterned portion.

14. The method of clause 13, wherein combining the first and second encoded data to generate the encoding of the patterned portion comprises concatenating the first and second encoded data to generate the encoding of the patterned portion.

15. The method of any preceding clause, wherein at least one of the first metrology system and the second metrology system is a real-world metrology system.

16. The method of any preceding clause, wherein at least one of the first metrology system and the second metrology system is a simulated metrology system.

17. The method of any preceding clause, wherein the neural network further comprises an application-specific model corresponding to an application type, from a set of application types, associated with the patterned portion, the application-specific model being configured to process data from the input network and to provide data to the output network data, and wherein the predicted metrology data is generated by processing the encoding of the patterned portion using the output network of the neural network and the data provided by the application model, wherein the application-specific model has been trained by a process in which the application-specific model processes data based on training metrology data of patterned portions associated with the application type.

18. The method of any preceding clause, wherein the configuration data of the first metrology system comprises setting data specifying operating parameters of the first metrology system.

19. The method of any preceding clause, wherein the configuration data of the first metrology system comprises data characterizing the first metrology system.

20. The method of any preceding clause, wherein the configuration data of the first metrology system comprises reference metrology data of a reference target generated using the first metrology system configured in the same configuration as used to generate the received metrology data.

21. The method of any preceding clause, wherein the metrology data comprises image data.

22. The method of clause 21, wherein the different metrology systems are different instances of an optical dark-field microscope.

23. The method of clause 22, wherein the configuration data of the first metrology system comprises information specifying a spectral density of light used to generate the metrology data.

24. The method of any preceding clause, wherein the different metrology systems are different beams of a multi-beam scanning electron microscope.

25. The method of any preceding clause, wherein the metrology data comprises a pupil representation defining a distribution of radiation in a pupil plane of the metrology system.

26. The method of any preceding clause, wherein the neural network model comprises a U-Net architecture.

27. The method of any preceding clause, wherein the neural network model comprises one or more skip connections.

28. The method according to clause 27, when dependent on clause 9, wherein the one or more skip connections comprise at least one skip connection from the common input model to the common output model.

29. The method according to any preceding clause, when dependent on clause 6, wherein the first metrology system and the second metrology system are the same metrology system, and wherein the target configuration data specify a configuration of the metrology system that is different from the configuration used to generate the metrology data.

30. The method according to any preceding clause, when dependent on clause 6, further comprising processing the predicted metrology data to determine one or more performance parameters.

31. The method according to clause 30 further comprising:

processing the one or more performance parameters to generate updated target configuration data, and
processing, using the neural network, the metrology data, the configuration data of the first metrology system and the updated target configuration data to generate updated predicted metrology data.

32. A method of training a neural network for generating predicted metrology data of a patterned portion of a substrate patterned using a lithographic apparatus, the neural network comprising an input network and a output network, the input network comprising a common input model and a specific input model, wherein specific input model is associated with a first metrology system, the neural network configured to:

receive metrology data of the patterned portion generated using the first metrology system;

receive configuration data specifying a configuration of the first metrology system used to generate the metrology data;

process, using the common input model and the specific input model, the metrology data and the configuration data to generate an encoding of the patterned portion; and

process, using the output network of the neural network, the encoding of the patterned portion to generate the predicted metrology data, the predicted metrology data being a prediction of metrology data which would have been generated by inspecting the patterned portion using a second metrology system.

33. The method of clause 32, wherein the method comprises obtaining a training dataset comprising first training metrology data generated using the first metrology system, configuration data specifying a configuration of the first metrology system used to generate the first training metrology data, and a second training metrology data generated using the second metrology system, wherein the first and second training metrology data have been generated by inspecting the same patterned portion of a training substrate patterned by the, or a further, lithographic apparatus.

34. The method according to clause 33, wherein the method comprises processing, using the common input model and the specific input model, the first training metrology data and the corresponding configuration data to generate an encoding of the patterned portion.

35. The method according to clause 33 or 34, wherein the method comprises processing, using the output network of the neural network, the encoding of the patterned portion to generate predicted second training metrology data, the predicted second training metrology data being a prediction of metrology data which would have been generated by inspecting the patterned portion using the second metrology system.

36. The method according to clause 35, wherein the method comprises updating weights of the neural network to reduce a measure of the discrepancy between the predicted second training metrology data and the second training metrology data.

37. The method of any of clauses 32 to 36, wherein the input network comprises a plurality of specific input models, each specific input model being associated with a different respective metrology system of a plurality of metrology systems comprising at least the first and second metrology systems and a third metrology system.

38. The method of clause 37, wherein the neural network is configured to process the metrology data and the configuration data to generate an encoding of the patterned portion by:

processing, using the common input model, the metrology data to generate an encoding of the metrology data; and

processing, using the specific input model of the first metrology system, the encoding of the metrology data and the configuration data to generate the encoding of the patterned portion, wherein the training dataset further comprises third training metrology data generated using the third metrology system, configuration data specifying a configuration of the third metrology system used to generate the third training metrology data, and fourth training metrology data generated using the second metrology system, wherein the third and fourth training metrology data have been generated by inspecting the same patterned portion of a respective training substrate patterned by the, or a further, lithographic apparatus;

the method further comprising:

processing, using the common input model, the third training metrology data to generate an encoding of the third training metrology data; and

processing, using the specific input model of the third metrology system, the encoding of the third training metrology data and the corresponding configuration data of the third metrology system to generate the encoding of the patterned portion,

processing, using the output network of the neural network, the encoding of the patterned portion to generate predicted fourth training metrology data, the predicted fourth training metrology data being a prediction of metrology data which would have been generated by inspecting the patterned portion using the second metrology system; and

updating weights of the neural network to reduce:

a measure of discrepancy between the predicted fourth training metrology data and the fourth training metrology data.

39. The method of clause 38, wherein the output network comprises a common output model and a plurality of specific output models, each specific output model associated with a different metrology system of the plurality of metrology systems,

wherein the neural network is configured to process the encoding of the patterned portion to generate the predicted metrology data by:

processing, using the specific output model of the second metrology system, the encoding of the patterned portion and target configuration data to generate the encoding of the predicted metrology data; and

processing, using the common output model, the encoding of the predicted metrology data portion to generate the predicted metrology data,

wherein the training dataset further comprises fifth training metrology data generated using the first metrology system, configuration data specifying a configuration of the first metrology system used to generate the fifth training metrology data, a sixth training metrology data generated using the third metrology system, and configuration data specifying a configuration of the third metrology system used to generate the sixth training metrology data, wherein the fifth and sixth training metrology data have been generated by inspecting the same patterned portion of a respective training substrate patterned by the, or a further, lithographic apparatus;

the method further comprising:

processing, using the common input model, the fifth training metrology data to generate an encoding of the fifth training metrology data; and

processing, using the specific input model of the first metrology system, the encoding of the fifth training metrology data and the corresponding configuration data of the first metrology system to generate an encoding of the patterned portion,

processing, using the specific output model of the third metrology system, the encoding of the patterned portion and the corresponding configuration data of the third metrology system to generate an encoding of predicted sixth training metrology data; and

processing, using the common output model, the encoding of the predicted sixth metrology data to generate the predicted sixth training metrology data,

updating weights of the neural network to reduce:

a measure of discrepancy between the predicted sixth training metrology data and the sixth training metrology data.

40. The method according of clause 39, wherein the first metrology system and the third metrology system are the same metrology system, and the corresponding configuration data specify the same configuration of the metrology system.

41. The method of any of clams 37 to 40, wherein the plurality of metrology systems comprises at least one simulated metrology system.

42. A computer program product comprising machine-readable instructions which, when the program is executed by a computer, cause the computer to carry out the method of any preceding clause.

43. A computer system comprising a processor and a data storage device, the data storage device storing program instructions which, when executed by the processor, cause the processor to carry out the method of any one of clauses 1 to 41.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

**Claims**

1. A method of generating, using a neural network, predicted metrology data of a patterned portion of a substrate patterned using a lithographic apparatus, the neural network comprising an input network and an output network, the input network comprising a common input model and a specific input model, wherein the common input model has been trained by a process in which the common input model processes data based on training metrology data generated by a plurality of metrology systems, and the specific input model has been trained by a process in which the specific input model processes data based on training metrology data generated only by a first metrology system, the method comprising:

   receiving metrology data of the patterned portion generated using the first metrology system;
   obtaining configuration data specifying a configuration of the first metrology system used to generate the metrology data;
   processing, using the common input model and the specific input model, the metrology data and the configuration data to generate an encoding of the patterned portion; and
   processing, using the output network of the neural network, the encoding of the patterned portion to generate the predicted metrology data, the predicted metrology data being a prediction of metrology data which would have been generated by inspecting the patterned portion using a second metrology system.

2. The method of claim 1, wherein a first one of the common input model and the specific input model is configured to process the metrology data to generate an encoding of the metrology data, and a second one of the common input model and the specific input model being configured to process the encoding of the metrology data.

3. The method of claim 2 in which the first one of the common input model and the specific input model is the common input model, and the second one of the common input model and the specific input model is the specific input model.

4. The method of claim 2 or 3, wherein processing the metrology data and the configuration data to generate an encoding of the patterned portion comprises:

   processing, using the first one of the common input model and the specific input model, the metrology data to generate an encoding of the metrology data; and
   processing, using the second one of the common input model and the specific input model, the encoding of the metrology data and the configuration data to generate the encoding of the patterned portion.

5. The method of any of claims 2 to 4, wherein the plurality of metrology systems used in the process to train the common input model comprise the first metrology system, the second metrology system and at least one further metrology system.

6. The method of any preceding claim further comprising a step of obtaining target configuration data specifying a configuration of the second metrology system, and wherein the predicted metrology data is a prediction of metrology data which would have been generated by inspecting the patterned portion using the second metrology system configured according to the target configuration data.

7. The method of any preceding claim, wherein at least one of the first metrology system and the second metrology system is a real-world metrology system.

8. The method of any preceding claim, wherein at least one of the first metrology system and the second metrology system is a simulated metrology system.

9. The method of any preceding claim, wherein the configuration data of the first metrology system comprises one or more of

   setting data specifying operating parameters of the first metrology system,
   data characterizing the first metrology system, and
   reference metrology data of a reference target generated using the first metrology system configured in the same configuration as used to generate the received metrology data.

10. The method of any preceding claim, wherein the metrology data comprises image data.

11. The method of any preceding claim, wherein the different metrology systems are different beams of a multi-beam scanning electron microscope.

12. The method of any preceding claim, wherein the metrology data comprises a pupil representation defining a distribution of radiation in a pupil plane of the metrology system.

13. A method of training a neural network for generating predicted metrology data of a patterned portion of a substrate patterned using a lithographic apparatus, the neural network comprising an input network and a output network, the input network comprising a common input model and a specific input model, wherein specific input model is associated with a first metrology system, the neural network configured to:

> receive metrology data of the patterned portion generated using the first metrology system;
> receive configuration data specifying a configuration of the first metrology system used to generate the metrology data;
> process, using the common input model and the specific input model, the metrology data and the configuration data to generate an encoding of the patterned portion; and
> process, using the output network of the neural network, the encoding of the patterned portion to generate the predicted metrology data, the predicted metrology data being a prediction of metrology data which would have been generated by inspecting the patterned portion using a second metrology system.

14. A computer program product comprising machine-readable instructions which, when the program is executed by a computer, cause the computer to carry out the method of any preceding claim.

15. A computer system comprising a processor and a data storage device, the data storage device storing program instructions which, when executed by the processor, cause the processor to carry out the method of any one of claims 1 to 13.

# Fig. 1

# Fig. 2

# Fig. 3

# Fig. 4

Neural network 400

| Tool k data 401 | → | Common input model 405 | → | Tool specific input model $\theta_k^e$ 407 | → | Tool specific output model $\theta_j^d$ 408 | → | Common output model 409 | → | Predicted Tool j data 404 |

406

Configuration 402

Configuration 403

# Fig. 5

S501 → receiving metrology data of a target generated using tool k

S502 → receiving configuration data specifying a configuration of tool k and tool j

S503 → processing the input metrology data and the configuration data of tool k to generate an encoding

S504 → processing the encoding to generate predicted metrology data

# Fig. 6

Training data 601

Plurality of training items
602

model input

network
parameters
604

Neural
Network
400

model output

target output

Training engine
603

# Fig. 7

<u>701</u>

Tool k data → | Common Input model → Specific input model $\theta_k^e$ → Specific output model $\theta_j^d$ → Common output model | → Predicted Tool j data ⟷ Measured Tool j data

<u>702</u>

Tool j data → | Common Input model → Specific input model $\theta_j^e$ → Specific output model $\theta_k^d$ → Common output model | → Predicted Tool k data ⟷ Measured Tool k data

<u>703</u>

Tool l data → | Common Input model → Specific input model $\theta_l^e$ → Specific output model $\theta_j^d$ → Common output model | → Predicted Tool j data ⟷ Measured Tool j data

<u>704</u>

Tool h data → | Common Input model → Specific input model $\theta_h^e$ → Specific output model $\theta_l^d$ → Common output model | → Predicted Tool l data ⟷ Measured Tool l data

<u>705</u>

Tool g data → | Common Input model → Specific input model $\theta_g^e$ → Specific output $\theta_g^d$ → Common output model | → Predicted Tool g data ⟷ Measured Tool g data

# Fig. 8

801

Tool k data → [Common Input model] → [Specific input model $\theta_k^e$] → [Specific output model $\theta_m^d$] → [Common output model] → Predicted Tool m data

→ [Common Input model] → [Specific input model $\theta_m^e$] → [Specific output model $\theta_j^d$] → [Common output model] → Predicted Tool j data ⟷ Measured Tool j data

# Fig. 9

901

Sim Tool k data → [Common Input model] → [Specific input model $\hat{\theta}_k^e$] → [Specific output model $\hat{\theta}_j^d$] → [Common output model] → Predicted Sim Tool j data ⟷ Sim Tool j data

# Fig. 10

Neural network 1000

Configuration 402

Tool k data 401 → Common Input model 1005

Configuration 403

Tool specific input model $\theta_k^e$ 1007

Tool specific output model $\theta_j^d$ 1008

combine 1010

Common output model 1009 → Predicted Tool j data 404

Skip connection(s)

# Fig. 11

Neural network 1100

| Tool k data 401 | → | Common input model 405 | → | Tool specific input model $\theta_k^e$ 407 | → | Common output model 1109 | → | Predicted reference tool data 1104 |

Configuration 402

# Fig. 12

Neural network 1200

| Tool k data 401 | → | Common input model 405 | → | Tool specific input model $\theta_k^e$ 407 | → | Tool specific output model $\theta_j^d$ 408 | → | Common output model 409 | → | Predicted Tool j data 404 |

Application specific module 1201

Configuration 402

Configuration 403

# Fig. 13

1300

1301

# Fig. 14

1400

1401

1402

# Fig. 15

# Fig. 16

Tool A

Tool B

Signal difference

1600

1601

1602

# Fig. 17

1700

1701

Tool A

Tool B mapped towards tool A

Signal difference

Europäisches
Patentamt

European
Patent Office

Office européen
des brevets

# EUROPEAN SEARCH REPORT

**Application Number**

EP 24 17 8687

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2022/238098 A1 (ASML NETHERLANDS BV [NL]) 17 November 2022 (2022-11-17) * paragraphs [0007], [0008], [0073] - [0075] * | 1-15 | INV. G03F7/20 G03F7/00 |
| | ----- | | |
| A | US 2023/418995 A1 (LI JIE [US] ET AL) 28 December 2023 (2023-12-28) * paragraphs [0005], [0006]; figure 6 * | 1-15 | |
| | ----- | | |
| A | US 2024/105522 A1 (PELED TOMER HAIM [IL] ET AL) 28 March 2024 (2024-03-28) * paragraphs [0006] - [0008], [0118], [0119]; figure 6 * | 1-15 | |
| | ----- | | |
| A | WO 2023/036593 A1 (ASML NETHERLANDS BV [NL]) 16 March 2023 (2023-03-16) * paragraphs [0006] - [0011], [0043] * | 1-15 | |
| | ----- | | |
| | | | **TECHNICAL FIELDS SEARCHED (IPC)** |
| | | | G03F |

The present search report has been drawn up for all claims

| Place of search | Date of completion of the search | Examiner |
|---|---|---|
| Munich | 21 November 2024 | Eisner, Klaus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 17 8687

This annex lists the patent family members relating to the patent documents cited in the above-mentioned European search report.
The members are as contained in the European Patent Office EDP file on
The European Patent Office is in no way liable for these particulars which are merely given for the purpose of information.

21-11-2024

| Patent document cited in search report | | Publication date | Patent family member(s) | | Publication date |
|---|---|---|---|---|---|
| WO 2022238098 | A1 | 17-11-2022 | CN | 117296014 A | 26-12-2023 |
| | | | EP | 4089484 A1 | 16-11-2022 |
| | | | IL | 307907 A | 01-12-2023 |
| | | | TW | 202309670 A | 01-03-2023 |
| | | | US | 2024184219 A1 | 06-06-2024 |
| | | | WO | 2022238098 A1 | 17-11-2022 |
| US 2023418995 | A1 | 28-12-2023 | TW | 202401303 A | 01-01-2024 |
| | | | TW | 202403675 A | 16-01-2024 |
| | | | US | 2023417682 A1 | 28-12-2023 |
| | | | US | 2023418995 A1 | 28-12-2023 |
| | | | WO | 2023250151 A1 | 28-12-2023 |
| | | | WO | 2023250152 A1 | 28-12-2023 |
| US 2024105522 | A1 | 28-03-2024 | CN | 117726895 A | 19-03-2024 |
| | | | KR | 20240039595 A | 26-03-2024 |
| | | | TW | 202431457 A | 01-08-2024 |
| | | | US | 2024105522 A1 | 28-03-2024 |
| WO 2023036593 | A1 | 16-03-2023 | CN | 115797251 A | 14-03-2023 |
| | | | EP | 4399573 A1 | 17-07-2024 |
| | | | JP | 2024536685 A | 08-10-2024 |
| | | | KR | 20240063929 A | 10-05-2024 |
| | | | TW | 202328821 A | 16-07-2023 |
| | | | TW | 202347048 A | 01-12-2023 |
| | | | US | 2024377343 A1 | 14-11-2024 |
| | | | WO | 2023036593 A1 | 16-03-2023 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6952253 B